# EUROPEAN PATENT SPECIFICATION

(11) **EP 3 198 056 B1**
(45) Date of publication and mention of the grant of the patent: **10.10.2018**
(21) Application number: 15780960.9
(22) Date of filing: 21.08.2015
(51) Int. Cl.: C23C 24/04, H05K 3/14, H01B 1/02

(54) **METHOD OF APPLYING ELECTRICALLY CONDUCTIVE BUS BARS ONTO LOW-EMISSIVITY GLASS COATING**
VERFAHREN ZUM ANBRINGEN VON ELEKTRISCH LEITENDEN SAMMELSCHIENEN AUF EINE EMISSIONSARME GLASBESCHICHTUNG
PROCÉDÉ D'APPLICATION DE BARRES OMNIBUS ÉLECTRIQUEMENT CONDUCTRICES SUR UN REVÊTEMENT DE VERRE À FAIBLE ÉMISSIVITÉ

(30) Priority: 25.09.2014 RU 2014138799
(43) Date of publication of application: 02.08.2017
(73) Proprietor: "Lascom" Limited Liability Company, g. Dubna 141983 (RU)
(72) Inventor: CHADIN, Valentin Sergeevich, Moskovskaya oblast pos. Obukhovo 142440 (RU); ALIEV, Timur Alekperovich, Moskovskaya oblast der. Bezdedovo 142440 (RU); ALIEV, Alekper Kamalovich, Moskovskaya oblast der. Bezdedovo 142440 (RU); MOTUZYUK, Artem Vasilievich, Moskovskaya oblast g. Dubna 141983 (RU)
(74) Representative: Grosse, Wolf-Dietrich Rüdiger
(86) International application number: PCT/RU2015/000530
(87) International publication number: WO 2016/048191

(56) References cited:
- WO-A1-2009/020804
- WO-A2-2013/158178
- US-A1- 2010 326 512

## Description

### Technical Field

The invention relates to the application of electrically conductive bus bars onto a low-emissivity coating of glass used, in particular, in the manufacture of electrically heated glass structures for transport, aviation, shipbuilding, armored vehicles (triplexes, bulletproof glass), glass packages, architectural glazing, etc.

### Background of the Invention

At present, the application of conductive bus bars onto a low-emissivity coating of glass is effected in the commercial production by a number of ways:
1. Process of applying a bus bar by ultrasonic soldering.
   The process is carried out by applying a solder (indium tin) using an ultrasonic soldering iron, which is reciprocated over a template at a speed of 2-5 mm/s. Then, to reduce the electrical resistance, a molybdenum tape mesh is applied over the solder by soldering.
   Disadvantages of this process are that it is manual, labor-intensive, low efficient and multi-staged; in addition, the method is expensive due to the high cost of the ultrasonic soldering iron, this imposing constraint on the provision of several soldering stations.
2. Process of applying conductive bus bars by screen printing method on an inkjet printer using a silicate-silver paste as the ink.
   Disadvantages of this process are also that it is a multi-staged (drying is added after application of the paste); the process uses expensive consumables and a high cost printer; there are difficulties with soldering current-carrying wires; furthermore, the bus bars applied by the method cannot operate under high heating power.
3. Process of applying bus bars by setting a metal strip with a glue line applied thereon, positioning the strip in the desired place and pressing to a low-emissivity coating in the triplexing process to provide electrical contact.
   Disadvantages of this process include unreliable electrical contact and reduced service life due to rapid aging of the structure in service.
4. Process of applying conductive bus bars onto a low-emissivity surface of glass by gas dynamic cold spray method.

The process of applying coatings by gas dynamic cold spray method was first disclosed in WO 9119016 A1 or US 5,302,414.

This method involves heating a compressed gas (air); supplying the gas into a supersonic nozzle to form there a supersonic flow; supplying a powder material into this flow; increasing the speed of the material by the supersonic flow and directing it through an outlet variable cross section nozzle onto a surface being processed.

This process is also known to be used for applying conductive bus bars on a low-emissivity glass surface. In particular, the method is currently used by Obninsk Center for Powder Spraying (http://dymet.info), as well as by CenterLine company (http://www.supersonicspray.com/).

In the procedure of applying bus bars onto a low-emissivity glass surface, this process is generally performed in a two stages, where the first stage comprises applying an underlayer of a powdered mixture of aluminum and zinc (to provide more adhesion), and then a layer of powdered mixture of copper and zinc is applied (to provide better electrical performance and facilitate soldering current-carrying wires to the bus bar). Each stage is carried out at specified flow temperature t°C and powder mass flow rate Q (g/s), at constant speed V (mm/s) of moving the nozzle and compressed air pressure P (atm). The process is carried out using templates or masks overlaid on the glass to form the geometric shape of the bus bar, especially its beginning and end. The process is carried out in an aspiration chamber whose design allows the application of only straight lines on one side of the product.

The conventional method has the following disadvantages:
inability to apply curvilinear bus bars as required for glasses having complex geometric shapes;
use of templates and masks for forming the beginning, end and discontinuities of the bus bars assumes securing them on the low-emissivity surface (with a sufficiently high pressing force), which can lead to its disruption and ultimately to defect product;
application of bus bars in an aspiration chamber containing a high concentration of suspended powder; the possibility of powder deposition on the surface of the product requires obligatory inclusion of washing and drying steps in the process, this leading to increased costs and to problems that arise in soldering current-carrying wires to the bus bar due to saturation of micropores of the bus bar with moisture;
restriction of the size of workpieces by dimensions of the aspiration chamber;
inability to integrate the process in a single production line since a separate room is required;
need to have a unique template for each workpiece;
inability of extremely tight pressing of all generators of the template against the glass surface, this resulting in blurred boundaries of the bus bar (powder blown upon the tray) and moire on its boundary, which is to be removed by acidic liquids;
inability of implementing the method to 3D models due to the complexity of installation and manufacture of templates and the aforementioned problems.

There are also several methods that can be used for applying bus bars to a limited extent, for example, reduction of copper on the surface of glass products from an autocatalytic solution by a laser-induced method, and sputtering metallic powders in a coaxial jet of powder and laser beam.

These methods cannot be generally practiced, by their nature, in commercial production for this process.

Therefore, the most technically relevant method is a method of applying bus bars onto a low-emissivity glass surface by gas dynamic cold spray method with the aid of a spraying nozzle of a gas dynamic spraying apparatus, disclosed in US 8,758,849 B2 and/or WO 2009/020804 A1.

The patents generally disclose the use of gas dynamic cold spray method in the process of applying conductive bus bars onto a low-emissivity glass surface.

It should be noted that the prior art documents are silent about a process of forming the beginning and end of the bus bar and about process steps that could enable practicing the method. The first patent only specifies that a mask can be used or not. However, the non-use of a mask in this method for forming the beginning and end of a bus bar is possible only if spraying is started and ended outside of the glass.

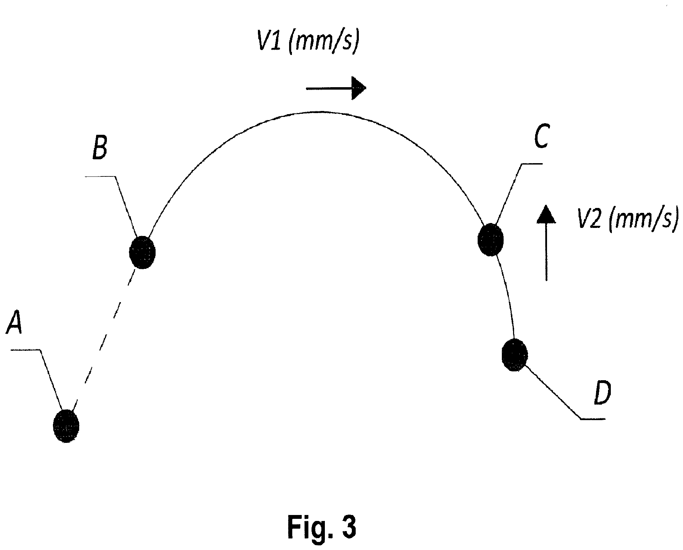

At the same time, as shown in Figs. 3, 4, 5, 7 of the document, the geometry of bus bars is obtained therein with the aid of masks, which is confirmed by the strictly linear geometry of the beginning and end of the bus bar, and none of the drawings shows the application of a bus bar without a mask, which would be demonstrated by a rounded geometry of the beginning or end of the bus bar. In practice, it is not possible to obtain the geometry without the use of masks. Therefore, the method does not provide for the ability of forming the bus bar beginning and end with distinct boundaries and geometric dimensions at any given area of the surface.

Analysis has shown that the above method has a number of other significant drawbacks that limit the abilities of its use in the process of applying bus bars onto a low-emissivity glass surface.

In particular, the method does not disclose the possibility of a delay in the powder supply into the nozzle as it is moving to a specified point on the surface. In this method the process is carried out traditionally, with feeding the powder into the nozzle before its positioning above the surface, and the supply is disabled upon going the nozzle beyond the surface, since there is no specific information on other embodiments of the process.

Furthermore, disadvantages of the prior art solution also include the following: the effect of delayed action of the spraying process when applying a broken line is not taken into account; the mechanism of feedback and its time range is not disclosed, taken into account that the process proceeds in motion and there is a delayed response in the action of actuators and the gas dynamic spraying apparatus, in particular, in the change of powder flow density; the presence of mechanical finishing of the resulting surface in the technological process.

The mechanism of aspiration of non-adherent powder and high concentration of non-removed suspended powder in the treatment area is undisclosed either.

The ability of powder deposition onto the surface of a product necessitates the inclusion of washing and drying steps in the process, which leads to increased costs and problems that arise in soldering current-carrying wires to the bus bar due to the saturation of micropores of the bus bar with moisture. Since the process involves the use of an aspiration chamber, the size of workpieces is restricted by the aspiration chamber dimensions, and the process cannot be integrated in a single production line since a separate room is required.

The second patent document describes a method of applying bus bars onto a glass surface by gas dynamic cold spray, wherein the spraying nozzle is moved to a beginning point of the bus bar without supplying powder into the nozzle, and upon being positioned at the beginning point of the bus bar, powder is supplied to the nozzle and the nozzle is moved with a constant speed from the beginning point to an endpoint of the bus bar.

### Disclosure of the Invention

The object of the present invention is to provide a method which could overcome the aforementioned disadvantages of the prior art.

In particular, the basic object of the invention is to enable the formation of an electrically conductive bus bar having distinct boundaries and geometric dimensions at the beginning, end and discontinuities of its path in any given area on the glass surface without the use of special templates and masks.

The object is attained in a method of applying electrically conductive bus bars onto a low-emissivity surface of glass by gas dynamic cold spray method with the aid of a spraying nozzle of a gas dynamic spraying apparatus, the method comprising:
providing in the gas dynamic spraying apparatus an estimated bulk weight of a powder, sufficient for spraying the powder over the entire length of the bus bar;
moving the spraying nozzle to a beginning point of the bus bar without supplying the sprayed powder thereto, and
upon positioning the moved nozzle at the beginning point of the bus bar, supplying the sprayed powder into the spraying nozzle and moving the spraying nozzle with a constant speed from the beginning point to an end point of the bus bar;
wherein upon reaching the end point of the bus bar, the nozzle movement is reversed towards the beginning point of the bus bar with a speed greater than the speed of the nozzle from the beginning point to the end point of the bus bar.

The reversed movement of the nozzle is preferably effected over a distance of about 2-3 cm.

The provision of an estimated bulk weight of the powder, sufficient for spraying the powder over the entire length of the bus bar, upon reaching a predetermined point of the path is preferably effected for an estimated part of a feed pipe by cutting off this part from a feeder by means of air valves further mounted in the gas dynamic spraying apparatus.

In a preferred embodiment, the bulk weight of the powder formed in the cut off part of the feed pipe is determined with account of the length of the applied area of the bus bar, its section and geometry, and is calculated based on process parameters accepted in the process, such as temperature, powder flow rate, compressed air pressure, and speed of the nozzle.

Preferably the sprayed powder is a fine powder, such as a homogeneous powder or a mixture of powders, the size of the applied fine powder being 5-5.0 µm.

Preferably, according to the present method a single-layer bus bar can be applied using a two-component powder, for example, Al+Zn, at a temperature of about 240°C, to provide a sufficient adhesion in combination with a higher (up to 3 times) utilization rate of the powder, and then a second layer of powdered copper (Cu) can be applied onto the edge of the bus bar (in the place of soldering a current-carrying wire) to provide a contact pad for soldering, which provides the best contact between the bus bar and the current-carrying wire when soldering. This is preferable for the electrically heated glass structures, where the adhesion of the powder to a low-emissivity glass surface, achieved in this case, satisfies the service conditions (for example, in architectural glazing).

To enhance adhesion of the powder to the glass surface, before applying the powder onto the glass surface, a part of the surface along the path, over which the bus bar is to be applied, is preferably treated with an abrasive powder, e.g. Al₂O₃ corundum, to partially remove the low-emissivity layer and thereby increase the relief of the surface of penetration of the powder into the glass. In this case, the material of the bus bar is then disposed with an offset of 2-3 mm from the axis of the application path to ensure electrical contact of the bus bar with the low-emissivity glass surface around said part with removed low-emissivity layer, i.e. to maintain its electrical contact with the low-emissivity glass surface.

Furthermore, the beginning and/or end points of the bus bar can be disposed both on the low-emissivity surface and on the part of the surface with removed low-emissivity layer.

The applying of the bus bar is preferably effected in two stages, where the first stage comprises applying the powder for forming an underlayer of the bus bar, and the second stage comprises applying the fine powder to form the final bus bar. At the two-stage application of the bus bar (application of two layers of powders having different composition) the underlayer is preferably a mixture of powdered zinc with polishing powders (for example, Fe₂O₃; CeO₂, etc.).

The process of applying the powder is preferably controlled by software, into which delay functions are introduced to take into account the delayed action of the gas dynamic spraying apparatus.

The method further comprises withdrawing dust and gas mass from the powder application area with the aid of a gas dynamic dust and gas ejection valve mounted on the spraying apparatus coaxially with the nozzle; wherein the ejecting jet in the dust and gas ejection valve is the jet of sprayed powder as such, which provides aspiration of the mass of powder non adherent to the surface.

In this application, the term "low-emissivity glass surface" refers to an energy saving glass typically used in glass packages and having a metallic coating that transmits light almost like an ordinary glass, but is able to reflect back into the room most of the thermal radiation or the long wave component of the radiation.

"Gas dynamic cold spray method" refers to the technology described above, which in other countries may have different names (including such terms as: gas dynamic cold spray process; cold spray; kinetic energy spray, or other combinations of these terms).

The method according to the invention offers the following technical advantages:
The method enables forming a bus bar having distinct boundaries and geometric dimensions in the beginning, end and discontinuities in its path in any given area of the surface without the use of special templates and masks, which are usually secured to the low-emissivity surface of glass and lead to disruption of this surface.

The method enables a delay in the powder supply into the nozzle as the nozzle is moving to a desired point on the surface, in particular, owing to including a delay function in the software and adapting it to the process.

Owing to the properly chosen exposure time and flow rate of the powder, a bus bar can be formed with an equal cross-section throughout its length, including the bus bar beginning and its end.

Design and process solutions that implement the method in practice enable the application of bus bars both in 2D models and 3D models, onto external and internal surfaces.

With the aid of ejection of dust and gas mass in the gas dynamic ejection valve, the sprayed powder jet provides aspiration of the mass of powder non adherent to the surface of up to 99.5% of the total weight, where 0.5% of non-aspirated powder is not in the suspended form, but is deposited on the surface of the glass and can be removed from the bus bars by wiping with a wad.

Process equipment used in this method can be integrated into the existing process of manufacturing electrically heated glasses; this automates the process, reduces the number of process steps, and improves the performance of electrically heated products owing to optimized configuration of the bus bars and reduced cost of their production. Efficiency of the step of applying bus bars onto glass is increased by 5-6 times.

### Brief Description of the Drawings

Hereinafter the invention will be explained in more detail by describing a particular embodiment in conjunction with the accompanying drawings, where:
Fig.1 shows schematically a gas dynamic spraying apparatus used for implementing the present method;
Fig.2 shows two projections of an external view of the used gas dynamic spraying apparatus;
Fig.3 shows a flow chart of the method; and
Fig.4 illustrates the arrangement of electrically conductive bus bars on the surface of a low-emissivity glass.

### Detailed Description of the Invention

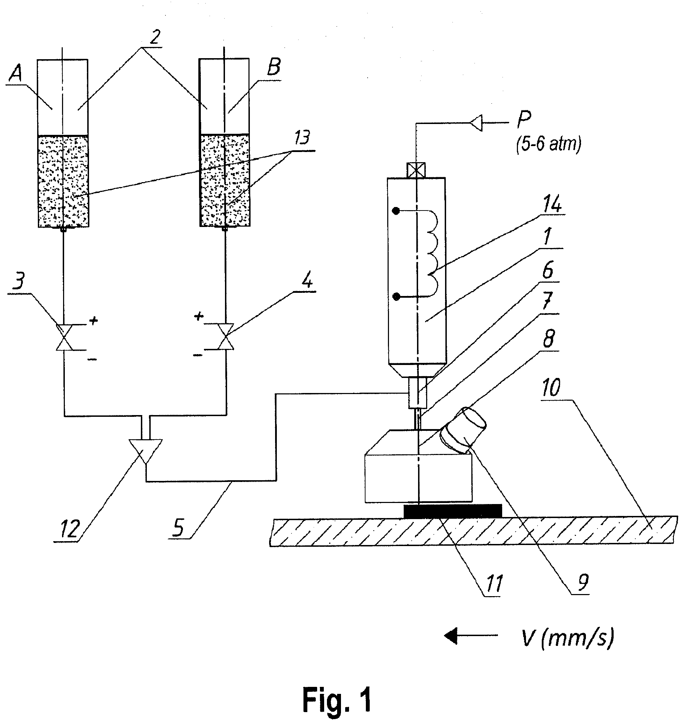

Fig.1 shows schematically a gas dynamic spraying apparatus used in this method, which comprises a spray gun 1, two feeders 2 with powders 13, connected to the spray gun 1 via feed pipes 5. In addition, the design of the conventional gas dynamic spraying apparatus has been modified by installation of additional air valves 3, 4 on the feed pipes 5, which, as will be shown, enable applying bus bars 11 onto any place of glass surface 10 without masks and templates.

The spray gun 1 comprises an air heater 14, a Laval nozzle 6 and an outlet variable cross-section nozzle 7. Each of the feeders 2 is connected alternately using a tee 12 via the pipes 5 to the outlet nozzle 7.

Furthermore, in one embodiment, a dust and gas ejection valve 8 can be mounted on the outlet nozzle 7, in which the ejecting jet is the jet of sprayed powder per se.

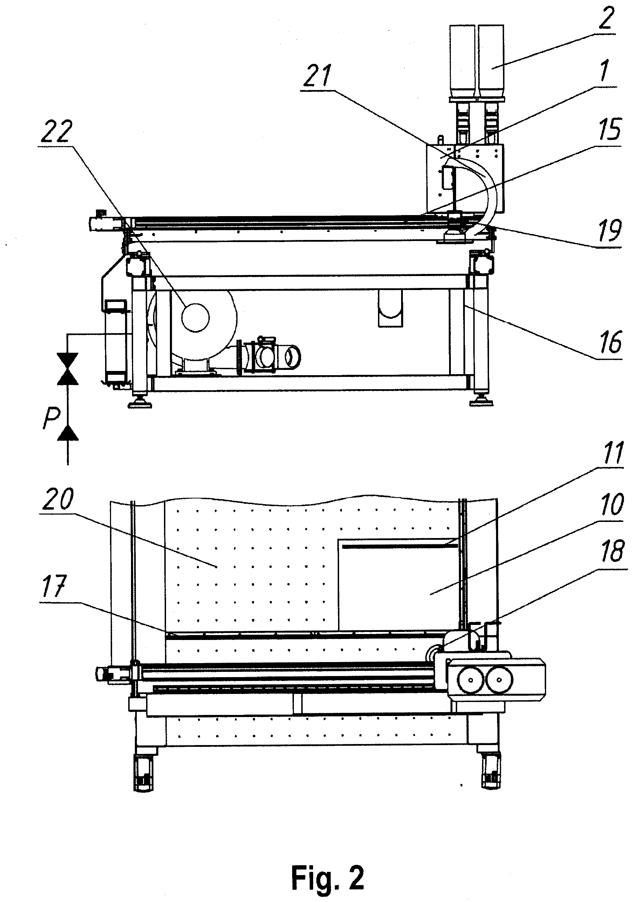

As also shown in Fig.2, the apparatus includes a three-axis table comprising a table frame 16, stops 17 for positioning glass 10 on the table, a bridge 15, and a bridge carriage 19. The plan view also shows a casing 18 of the valve 8 and injectors 20 to provide air support to the glass 10, the injectors being connected to an air blower 22; and the side view shows an aspiration channel 21 connected at one end to the casing 18 of the valve 8, which is connected with a hose 9 of the aspiration system.

The apparatus further comprises a control stand with power supplies and industrial PC (not shown in Figs.1 and 2) .

A method according to the present invention is performed as follows.

As explained above, the gas dynamic cold spray technique used in the method involves heating a compressed gas (air), supplying it into a supersonic nozzle and forming a supersonic flow therein, and supplying a powder material into the flow, increasing the speed of the material by the supersonic flow and directing it through an outlet variable cross section nozzle onto the workpiece surface.

The process of applying bus bars is carried out using LDesigner software product (ATEKO Company), to which a delay function is added to take into account the delayed response of the equipment and to adapt it to the process.

LDesigner 5.0 software product consists of two parts:
(a) Graphic editor (LDesigner 5.0 Graphic Editor), which provides wide opportunities for creating, editing and processing images. Its main features include a modern, easy to use graphical interface (including detailed menus, toolbars, hotkeys, image editing using the mouse) and the ability to work with vector and raster graphics created using popular graphics editors (such as CorelDraw or AutoCAD); and
(b) Marker (LDesigner 5.0 Marking Program), which controls the three-axis table and process equipment.

The marker implements the algorithm of applying bus bars onto the glass, created in the LDesigner.

The process is carried out in the following sequence:
- a graphic file of contour of the glass product with applied bus bars is generated in the graphic editor; furthermore, process conditions are specified for each object:
- speed of movement of the nozzle, v mm/s;
- number of working feeder 2 (Fig. 1);
- temperature corresponding to the sprayed powder contained in the feeder;
- process (program) delays for the beginning of the application process, Δt (ms), and the end of the application process, Δt (s);
- powder mass flow rate Q (g/s) (to provide an estimated bulk weight of the powder in the gas dynamic spraying apparatus, sufficient for applying the powder over the entire length of the bus bar);
- working air pressure (atm);
- sequence of processing the objects.

Operator starts the "Marker" program at the control stand, thereby providing implementation of the specified project and carrying out the process of applying bus bars.

With that, a spraying nozzle of the spray gun 1 is moved to beginning point B of the bus bar 11 without supplying the sprayed powder therein, and upon positioning the moved nozzle at the beginning point B of the bus bars 11 the sprayed powder is admitted into the nozzle, and the spraying nozzle is moved with a constant speed from the beginning point B towards end point D of the bus bar (see Fig.3). Upon reaching the end point D of the bus bar, the nozzle movement is reversed towards the beginning point B of the bus bar with a speed greater than the speed of the nozzle from the beginning point B to the end point D of the bus bar.

The process of applying bus bars can be either single-stage or multi-stage, where an underlayer is pre-applied of a powder exhibiting better "wettability" to the glass to increase the adhesion of the bus bar to the low-emissivity surface of the glass.

The gas dynamic cold spray process is carried out using powders with a fraction of 5 to 50 µm; it is generally a mixture of powders of several components, one of which exhibits a better "wettability" to the surface, and the other exhibits adhesion and cohesion. This combination of powders is typical for the underlayer, while the second and subsequent layers generally consist of components that enhance the electrical and process properties. For example, a mixture of copper and zinc (or pure copper) reduces the electrical resistance and simplifies the process of soldering current-carrying wires. Using the above combination of compositions of powders and alternating the layers a bus bar can be produced that is capable of conducting high currents without temperature gradient between the bus bar and the electrically heated surface.

Bulk weight of the powder, formed in the cut-off part of the feed pipes, is calculated using known formulas and adjusted at experimental weighing and experimental sputtering of these bulk volumes on a sample of the bulk weight at the process parameters accepted in the process:
- temperature, t °C;
- powder flow rate, Q g/s;
- compressed air pressure, P atm;
- speed of the nozzle, v mm/s;
with determining the length of the applied area of the bus bar, its cross section and geometry.

Owing to the properly chosen exposure time (τ=d/v(sec), where d is the diameter of the spraying nozzle, v is the speed of its movement relative to the low-emissivity surface) and the powder flow rate, a bus bar is formed that has an equal cross-section throughout its length, including the beginning of the bus bar and its end.

The use of an air dynamic dust and gas ejection valve 8, in which, as mentioned, the ejecting jet is the working spraying jet, and which is mounted coaxially on the spraying nozzle 7, enables the process to be implemented without a special aspiration chambers, therefore the method and the equipment developed on its basis can be integrated in the existing process of manufacturing electrically heated glass to replace low efficient and costly processes and construct fully automated lines.

### Example of Implementing the Method

To carry out the present method, the described above apparatus was used with "DIMET" gas dynamic spraying system (Model 423) supplied from the aforementioned Obninsk Center for Powder Spraying, which was supplemented with required additions relating to installation of additional air valves and the air dynamic dust and gas ejection valve.

An example will be described for a two-stage method of applying bus bars, wherein:
- the first stage comprises applying a bus bar underlayer of a composition of Al+Zn powders in the ratio of 50/50 to provide maximum adhesion of powders to the low-emissivity surface (not less than 100 MPa); and
- the second stage comprises applying a composition of Cu+Zn powders in the ratio of 70/30 to improve electrical characteristics of the bus bar (decrease the electrical resistance) and to facilitate the process of soldering current-carrying wires from the power supply to the bus bar.

Process engineer creates in the LDesigner graphic editor a graphic file of the project with applied electrically conductive bus bars and specifies process parameters for each object:
- number of feeder 2;
- temperature of spraying jets, T, degrees C (200 - 300°C) ;
- mass flow rate of powder, Q, g/s (0.6 g/s);
- speed of the nozzle when spraying the bus bar, v, mm/s (40 mm/s);
- thickness of glass to be processed;
- process delay, t, (C), for powder supply when forming the beginning of the bus bar;
- process delay for cutting off the currently running feeder 2 from feed pipe 5 (Fig.1);

Next, the process engineer generates the algorithm for applying bus bars, determines the processing sequence and imports the generated project in LDesigner "Marker" program.

The apparatus operator performs the following actions:
- puts glass on the surface of a three-axis table in an air layer created by the blower 22 and the injectors 20 for air support, and positions it by stops 17 (Fig.2);
- provides suction clamp by switching a gate (not shown);
- enables the supply of compressed air at a pressure of 5 to 6 atm;
- actuates the aspiration system;
- starts the "Marker" program.

Further, the process of applying bus bars runs automatically on the specified algorithm and the predetermined parameters.

A solenoid valve (not shown) of the gas dynamic spraying apparatus opens, and compressed air enters the spray gun 1 and is heated there through the Laval nozzle 6 and increases its speed, and flows to the variable cross section nozzle 7 and further to the air dynamic dust and gas ejection valve 8 (Fig.1).

At the same time the air valve 3 opens and connects the first feeder 2 with the feed pipe 5 (Fig.1). Al+Zn powder enters from the feeder 2 due to ejection into the jet of heated compressed air, mixes with it and passes into the variable cross section outlet nozzle 7, which is currently above zero aspiration point A (Fig.3; in Fig.2 the point is under the valve casing 18). The feed pipe is blown through by the powder from the first feeder 2 and is filled with it.

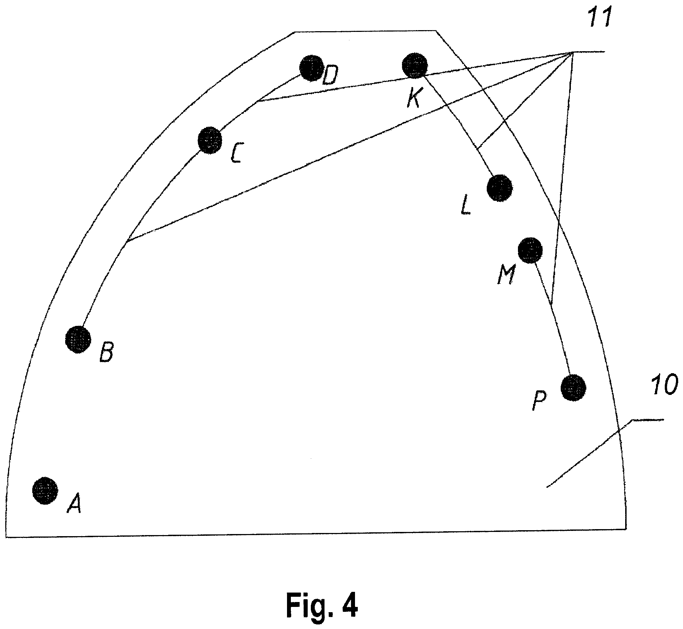

Next, the compressed air supply is shut off by closing a solenoid valve included in the system. With this, powder supply into the nozzle does not occur, and the nozzle moves from zero aspiration point A (Fig.2) to the beginning point B of the bus bar at the estimated time set by the delay in the program. At the instant when the nozzle 7 is moving above the point B, the solenoid valve opens, and compressed air is admitted, with the powder material spray exposure time of τ = d/v (sec), to form the bus bar beginning. Then, the nozzle 7 is moving with a constant speed, v mm/s, along the path of the sprayed bus bar towards the end point D of the bus bar. Upon reaching point C at the software set time a command is received to close the air valve 3 for cutting off the pipe 5 from the feeder 2. The estimated bulk weight of powder is formed in the pipe, which is sufficient to apply the bus bar length between points C and D. Upon reaching the point D with exposure time τ ≥ d/v (s) and at a greater speed than the constant speed, the movement of the nozzle along the path of the applied bus bar is reversed towards the beginning point A of the bus bar, preferably at 20-30 mm. The air valve 3 opens, the built-in solenoid valve shuts off the supply of compressed air, and the nozzle 7 is then moved to the beginning of the next bus bar, point K (Fig.4). Then, the same algorithm is run as in the case of the first bus bar. This is the procedure of the first stage - the stage of applying an underlayer of Al+Zn on all bus bars of the project (shown in Fig.4).

Then, the second stage, application of Cu+Zn powder composition, is carried out. Here, the spraying nozzle 7 is moved at idling speed to the zero aspiration point A (buil-in solenoid valve is closed). At the zero aspiration point A the solenoid valve opens, the air valve 3 closes and the air valve 4 opens. Thereby the second feeder 2 is operated, and the feed pipe and the spray gun are blown off from the Al+Zn powder and filled with Cu+Zn powder.

The process proceeds for 1.5-2 seconds. The spraying nozzle 7 is then moved from the point A to the point B according to the same algorithm as during the application of the bus bar underlayer, and the main layer of Cu+Zn powder is applied. The process parameters are the same, except that the temperature of the spraying jet is set in the range of from 240 to 400°C.

At that the process of forming a conductive bus bar on the low-emissivity glass surface is completed.

As will be apparent to persons skilled in the art based on the described invention, many changes and modifications may be made in the above-described and other embodiments of the present invention, not going beyond its scope defined in the appended claims.

For example, the provision of the estimated bulk weight of the powder, sufficient for applying the powder over the entire length of the bus bar, is not obligatory carried out by cutting off a part of the pipe upon reaching a specified point of the bus bar, but can also be calculated before moving the nozzle along the entire bus bar length.

Furthermore, although reference was made to some types of powders and their mixtures, it should be clear to those skilled in the art that other types of powders can be also used. Therefore, the above detailed description of a preferred embodiment should be taken as illustrative and not restrictive.

## Claims

1. A method of applying electrically conductive bus bars onto a low-emissivity surface of glass by gas dynamic cold spray method with the aid of a spraying nozzle of a gas dynamic spraying apparatus, the method comprising:
providing in the gas dynamic spraying apparatus an estimated bulk weight of a powder, sufficient for spraying the powder over the entire length of the bus bar;
moving the spraying nozzle to a beginning point of the bus bar without supplying the sprayed powder into the nozzle, and
upon positioning the moved nozzle at the beginning point of the bus bar, supplying the sprayed powder into the spraying nozzle and moving the spraying nozzle with a constant speed from the beginning point to an end point of the bus bar;
wherein upon reaching the end point of the bus bar, the movement of the nozzle is reversed towards the beginning point of the bus bar with a speed greater than the speed of the nozzle moving from the beginning point to the end point of the bus bar.

2. A method according to claim 1, wherein said reversed movement of the nozzle is effected over a distance of about 2-3 cm.

3. A method according to claim 1, wherein said providing of an estimated bulk weight of the powder, sufficient for spraying the powder over the entire length of the bus bar, upon reaching a specified point of the path is effected by cutting off an estimated part of a feed pipe from a feeder by means of air valves provided in the gas dynamic spraying apparatus.

4. A method according to claim 3, wherein the bulk weight of the powder, formed in the cut off part of the feed pipe, is determined with account of the length of the applied area of the bus bar, its section and geometry, and is calculated based on process parameters accepted in the process, such as temperature, powder flow rate, compressed air pressure, and speed of the nozzle.

5. A method according to claim 1, wherein the sprayed powder is a fine powder, such as a homogeneous powder or a mixture of powders, the size of the applied fine powder being 5-5.0 mµ.

6. A method according to claim 1 or 5, wherein a single-layer bus bar is applied using a two-component powder, for example, Al+Zn, at a temperature of about 240°C, and after said applying a second layer of powdered copper (Cu) is applied onto the edge of the bus bar to form thereon a contact pad for soldering.

7. A method according to claim 1 or 5, wherein said applying of the bus bar is effected in two stages, where the first stage comprises applying a powder to form an underlayer of the bus bar, and the second stage comprises applying the fine powder to form the final bus bar.

8. A method according to claim 1, wherein the process of applying the powder is controlled through a computer with software, into which delay functions are introduced, taking into account the delayed action of the gas dynamic spraying apparatus.

9. A method according to claim 1, wherein before applying the powder onto the glass surface, a part of the surface along the path, onto which the bus bar is to be applied, is treated with an abrasive powder, e.g. Al₂O₃, to partially remove the low-emissivity layer, and the bus bar material is then disposed with an offset of 2-3 mm from the axis of the application path to ensure electrical contact of the bus bar with the low-emissivity glass surface around said part with removed low-emissivity layer.

10. A method according to claim 9, wherein said beginning and/or end points of the bus bar are disposed on the low-emissivity surface or on said part of the surface with removed low-emissivity layer.

11. A method according to claim 1, further comprising withdrawing dust and gas mass from the powder application area with the aid of a gas dynamic dust and gas ejection valve mounted on the spraying apparatus coaxially with the nozzle; wherein the ejecting jet in the dust and gas ejection valve is the jet of sprayed powder as such, which provides aspiration of the powder mass non adherent to the surface.

## Patentansprüche

1. Verfahren zum Aufbringen von elektrisch leitenden Sammelschienen auf eine Oberfläche niedrigen Emissionsvermögens aus Glas durch ein gasdynamisches Kaltsprühverfahren mithilfe einer Sprühdüse einer gasdynamischen Sprühvorrichtung, das Verfahren umfassend:
Vorsehen, in der gasdynamischen Sprühvorrichtung, eines geschätzten Schüttgewichts eines Pulvers, das zum Sprühen des Pulvers über die gesamte Länge der Sammelschiene ausreichend ist;
Bewegen der Sprühdüse an einen Anfangspunkt der Sammelschiene, ohne dass das gesprühte Pulver in die Düse eingegeben wird, und
beim Positionieren der bewegten Düse am Anfangspunkt der Sammelschiene, Eingeben des gesprühten Pulvers in die Sprühdüse und Bewegen der Sprühdüse mit einer konstanten Geschwindigkeit von dem Anfangspunkt zu einem Endpunkt der Sammelschiene;
wobei beim Erreichen des Endpunkts der Sammelschiene die Bewegung der Düse in Richtung des Anfangspunkts der Sammelschiene mit einer Geschwindigkeit umgekehrt wird, die größer als die Geschwindigkeit der Düse ist, die sich von dem Anfangspunkt zu dem Endpunkt der Sammelschiene bewegt.

2. Verfahren nach Anspruch 1, wobei die umgekehrte Bewegung der Düse über eine Strecke von ungefähr 2 bis 3 cm ausgeführt wird.

3. Verfahren nach Anspruch 1, wobei das Vorsehen eines geschätzten Schüttgewichts des Pulvers, das zum Sprühen des Pulvers über die gesamte Länge der Sammelschiene ausreichend ist, beim Erreichen eines vorgegebenen Punkts des Wegs durch Abschneiden eines geschätzten Teils eines Zuführungsrohrs von einer Zuführungseinrichtung mittels Luftventilen ausgeführt wird, die in der gasdynamischen Sprühvorrichtung vorgesehen sind.

4. Verfahren nach Anspruch 3, wobei das Schüttgewicht des Pulvers, das in dem abgeschnittenen Teil des Zuführungsrohrs gebildet ist, unter Berücksichtigung der Länge des aufgebrachten Bereichs der Sammelschiene, dessen Querschnitts und Geometrie bestimmt wird, und auf Grundlage von Prozessparametern berechnet wird, die in dem Prozess akzeptiert sind, wie beispielsweise Temperatur, Pulverströmungsgeschwindigkeit, Druckluftdruck und Geschwindigkeit der Düse.

5. Verfahren nach Anspruch 1, wobei das gesprühte Pulver ein feines Pulver ist, wie beispielsweise ein homogenes Pulver oder ein Gemisch von Pulvern, wobei die Größe des aufgebrachten feinen Pulvers 5 bis 5,0 mµ beträgt.

6. Verfahren nach Anspruch 1 oder 5, wobei eine Einschicht-Sammelschiene mithilfe eines Zweikomponentenpulvers, beispielsweise Al+Zn, bei einer Temperatur von ungefähr 240°C aufgebracht wird, und nach dem Aufbringen eine zweite Schicht pulverisierten Kupfers (Cu) auf die Kante der Sammelschiene aufgebracht wird, um darauf eine Kontaktfläche zum Löten zu bilden.

7. Verfahren nach Anspruch 1 oder 5, wobei das Aufbringen der Sammelschiene in zwei Stufen ausgeführt wird, wobei die erste Stufe Aufbringen eines Pulvers, um eine Unterschicht der Sammelschiene zu bilden, umfasst, und die zweite Stufe Aufbringen des feinen Pulvers, um die endgültige Sammelschiene zu bilden, umfasst.

8. Verfahren nach Anspruch 1, wobei der Prozess des Aufbringens des Pulvers durch einen Computer mit Software gesteuert wird, in welcher Verzögerungsfunktionen eingeführt sind, die die verzögerte Wirkung der gasdynamischen Sprühvorrichtung berücksichtigt.

9. Verfahren nach Anspruch 1, wobei vor dem Aufbringen des Pulvers auf die Glasoberfläche ein Teil der Oberfläche entlang des Wegs, auf den die Sammelschiene aufgebracht werden soll, mit einem Schleifpulver behandelt wird, z.B. Al₂O₃, um die Oberfläche niedrigen Emissionsvermögens teilweise zu entfernen, und das Sammelschienenmaterial dann mit einem Versatz von 2 bis 3 mm von der Achse des Aufbringungswegs angeordnet wird, um elektrischen Kontakt der Sammelschiene mit der Glasoberfläche niedrigen Emissionsvermögens um den Teil mit entfernter Schicht niedrigen Emissionsvermögens herum sicherzustellen.

10. Verfahren nach Anspruch 9, wobei die Anfangs- und/oder Endpunkte der Sammelschiene auf der Oberfläche niedrigen Emissionsvermögens oder auf dem Teil der Oberfläche mit entfernter Schicht niedrigen Emissionsvermögens angeordnet sind.

11. Verfahren nach Anspruch 1, ferner umfassend Entnehmen von Staub und Gasmasse von dem Pulveraufbringungsbereich mithilfe eines gasdynamischen Staub- und Gas-Abstoßventils, das auf der Sprühvorrichtung koaxial zu der Düse angebracht ist; wobei der Abstoßstrahl in dem Staub- und Gas-Abstoßventil der Strahl von gesprühtem Pulver als solcher ist, der eine Ansaugung der Pulvermasse bereitstellt, die nicht an der Oberfläche haftet.

## Revendications

1. Procédé d'application de barres de bus électriquement conductrices sur une surface de verre à faible émissivité par un procédé de pulvérisation à froid dynamique de gaz à l'aide d'une buse de pulvérisation d'un dispositif de pulvérisation dynamique de gaz, le procédé comprenant de :
fournir dans le dispositif de pulvérisation dynamique de gaz une masse volumique estimée d'une poudre, suffisante pour pulvériser la poudre sur la totalité de la longueur de la barre de bus ; déplacer la buse de pulvérisation vers un point de début de la barre de bus sans alimenter la poudre pulvérisée dans la buse et
lors du positionnement de la buse déplacée au point de début de la barre de bus, alimenter la poudre pulvérisée dans la buse de pulvérisation et déplacer la bus de pulvérisation avec une vitesse constante du point de début à un point de fin de la barre de bus ;
dans lequel lorsque le point de fin de la barre de bus est atteint, le mouvement de la buse est inversé vers le point de début de la barre de bus avec une vitesse supérieure à la vitesse de la buse se déplaçant du point de début au point de fin de la barre de bus.

2. Procédé selon la revendication 1, dans lequel ledit mouvement inversé de la buse est effectué sur une distance d'environ 2-3 cm.

3. Procédé selon la revendication 1, dans lequel ladite fourniture d'une masse volumique estimée de la poudre, suffisante pour pulvériser la poudre sur la totalité de la longueur de la barre de bus, lorsqu'un point spécifié du trajet est atteint est effectuée en coupant une partie estimée d'un tuyau d'alimentation provenant d'un dispositif d'alimentation au moyen de soupapes d'air prévues dans le dispositif de pulvérisation dynamique de gaz.

4. Procédé selon la revendication 3, dans lequel la masse volumique de la poudre, formée dans la partie de découpe du tuyau d'alimentation, est déterminée en tenant compte de la longueur de la zone appliquée de la barre de bus, sa section et sa géométrie et est calculée sur la base des paramètres de processus acceptés dans le processus, tels que la température, le débit de poudre, la pression d'air comprimé et la vitesse de la buse.

5. Procédé selon la revendication 1, dans lequel la poudre pulvérisée est une poudre fine, telle qu'une poudre homogène ou un mélange de poudre, la taille de la poudre fine appliquée étant 5-5.0 mµ.

6. Procédé selon la revendication 1 ou 5, dans lequel une barre de bus à couche unique est appliquée en utilisant une poudre à deux composants, par exemple Al+Zn, à une température d'environ 240 °C, et après ladite application une seconde couche de cuivre en poudre (C) est appliquée sur le bord de la barre de bus pour former sur celui-ci une pastille de contact pour le brasage.

7. Procédé selon la revendication 1 ou 5, dans lequel ladite application de la barre de bus est effectuée en deux étapes, où la première étape comprend d'appliquer une poudre pour former une sous-couche de la barre de bus et la seconde étape comprend d'appliquer la poudre fine pour former la barre de bus finale.

8. Procédé selon la revendication 1, dans lequel le processus d'application de la poudre est commandé par l'intermédiaire d'un ordinateur avec logiciel, dans lequel les fonctions de retard sont introduites, en tenant compte de l'action retardée du dispositif de pulvérisation dynamique de gaz.

9. Procédé selon la revendication 1, dans lequel avant d'appliquer la poudre sur la surface de verre, une partie de la surface le long du trajet, sur laquelle la part de buse doit être appliquée, est traitée avec une poudre abrasive, par ex. Al₂O₃, pour éliminer partiellement la couche à faible émissivité et le matériau de barre de bus est ensuite disposé avec un décalage de 2-3mm de l'axe du trajet d'application pour garantir un contact électrique de la barre de buse avec la surface de verre à faible émissivité autour de ladite partie avec la couche à faible émissivité éliminée.

10. Procédé selon la revendication 9, dans lequel lesdits points de début et/ou fin de la barre de bus sont disposés sur la surface à faible émissivité ou sur ladite partie de la surface avec la couche à faible émissivité supprimée.

11. Procédé selon la revendication 1, comprenant en outre d'extraire la poussière et la masse gazeuse de la zone d'application de poudre à l'aide d'une soupape d'éjection de poussière et de gaz dynamique montée sur le dispositif de pulvérisation coaxialement à la buse ; dans lequel le jet d'éjection dans la soupape d'éjection de poussière et de gaz est le jet de poudre pulvérisé en tant que tel, qui fournit l'aspiration de la masse de poudre non adhérente à la surface.
